# EUROPEAN PATENT SPECIFICATION

(11) **EP 0 507 018 B1**
(45) Date of publication and mention of the grant of the patent: **05.07.1995**
(21) Application number: 91302967.4
(22) Date of filing: 04.04.1991
(51) Int. Cl.: H05K 7/14, G07B 17/00, H05K 5/04

(54) **Housing arrangement**
Gehäusestruktur
Arrangement de boîtier

(43) Date of publication of application: 07.10.1992
(73) Proprietor: Pitney Bowes PLC, Harlow Essex CM19 5BD (GB)
(72) Inventor: Simkins, Barry Wade, Harlow, Essex, CM18 7NX (GB); O'Neale, Brian Ronald, Harlow, Essex, CM20 3HU (GB)
(74) Representative: Cook, Anthony John

(56) References cited:
- US-A- 4 084 214
- US-A- 4 650 973
- HEWLETT-PACKARD JOURNAL vol. 36, no. 12, December 1985, AMSTELVEEN, NEDERLANDS pages 14 - 18; JEWELL, JOHNSON: 'Internally Modular Signal Generator Mechanical Design'

## Description

### HOUSING ARRANGEMENT

This invention relates to a housing arrangement including a key pad, a display, electronic circuitry, and a power supply unit. The invention is described herein with particular reference to a housing arrangement for certain parts of an electronic postage meter, but it will be realised that the present invention is likely to be applicable in other machines.

In the manufacture of machines such as postage meters, it is desirable to eliminate complex sheet forming pressing and other operations on sheet metal. It is also desirable to provide some form of heat sink whereby unwanted heat generated in the power supply unit can be effectively disipated, and it is further desirable to provide adequate shielding against radio frequency interference and electromagnetic induction effects as otherwise the proper operation of electronic circuitry in the machine may be compromised. Addionally, as well as meeting these to some extent conflicting requirements, it is desirable to have a housing arrangement which is relatively cheap to manufacture and easily assembled without intricate manipulating operations during manufacture.

The present invention aims to meet or at least substantially meet all or most of these objectives.

According to the present invention, there is provided a housing arrangement for use in a device including a keypad, a display, a main logic circuit board, and a power supply unit, the housing arrangement comprising:
(I) a first assembly comprising (a) a first die casting of zinc or other material having equivalent radio frequency interference shielding and electromagnetic induction shielding properties, (b) the keypad, and (c) the display; and
(II) a second assembly comprising a second die casting to an upper surface of which is attached the main logic circuit board and to a lower surface of which is attached the power supply unit, the second die casting being of a shape designed to cooperate and interfit with the first die casting.

For brevity in this specification the said zinc or other material is referred to merely as "shielding material" and use of the words "shielding material" in this specification and claims is to be taken to mean such material.

In a preferred embodiment of the invention, the first assembly die casting has front, rear and two side walls all integral with a sloping apertured top wall. The apertures in the top wall permit the display to be read and permit keypad buttons to extend upwardly through the die casting.

According to an advantageous embodiment of the invention, the second assembly die casting is substantially planar and has a rim which interfits with the lower edges of the die casting of the first assembly.

Preferably, but not necessarily, the first assembly comprises, assembled together in order, a metal support plate, an insulating plate, the display attached to a display support board, the keypad, and the first die casting, the first die casting being uppermost.

To provide electrical connection between the display and the main logic board, any suitable electrical connection means may be employed, but preferably a so-called flying ribbon comprising multiple electrical conductors is connected at one end to the display and at its other end to the main logic board. This is particularly useful in that it enables the first assembly to be separated a short distance away from the second assembly, if desired, without breaking the electrical connection between these two assemblies. Access for component replacement is therefore much easier due to this feature.

In a preferred particular embodiment of the invention, the housing assembly includes metal plates serving as heat sinks and attached to the second die casting. Such metal plates may be attached to, and one at each side of, the second die casting. They may be bolted on.

While reference has been made above to parts being attached to the second die casting on its lower and upper surfaces, it will be appreciated that the arrangement may be reversed if this is particularly desirable in certain circumstances. The arrangement illustrated herein is however preferred.

The broadest aspect of the present invention involves making a connection around their rims between first and second die castings, such connection preferably being by way of self-tapping or so-called "Taptite" screws.

The invention will be better understood from the following non-limiting description of an example thereof, given with reference to the accompanying drawings in which:-
Figures 1a-1g show in perspective exploded view various components which make up a first assembly in a housing arrangement according to one example of the invention;
Figure 2 is a similar view showing components which make up a second assembly in a housing arrangement according to the invention; and
Figure 3 is a similar view showing the first assembly about to be united with the second assembly and with side plates, to produce an example of a housing assembly according to the invention.

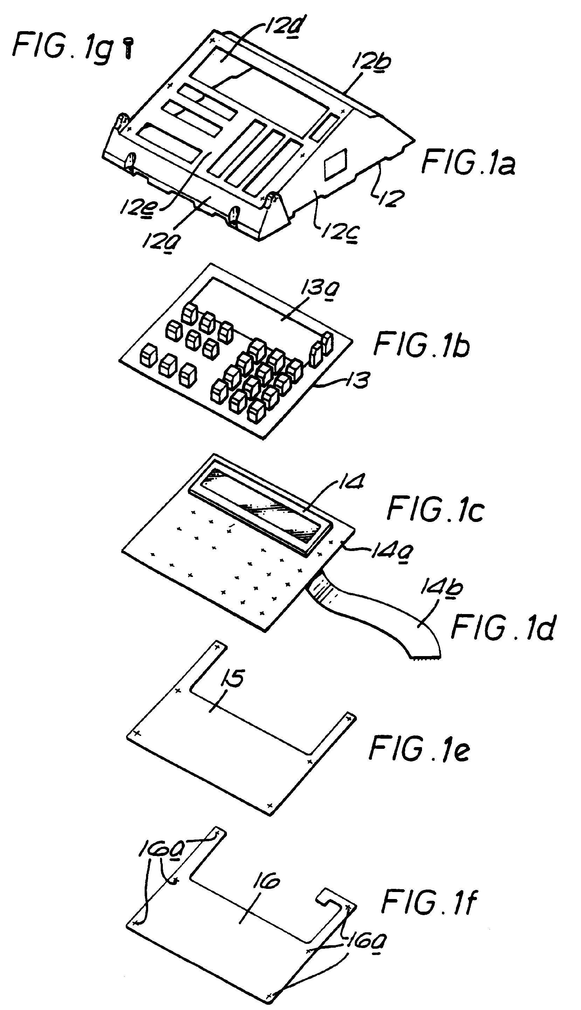

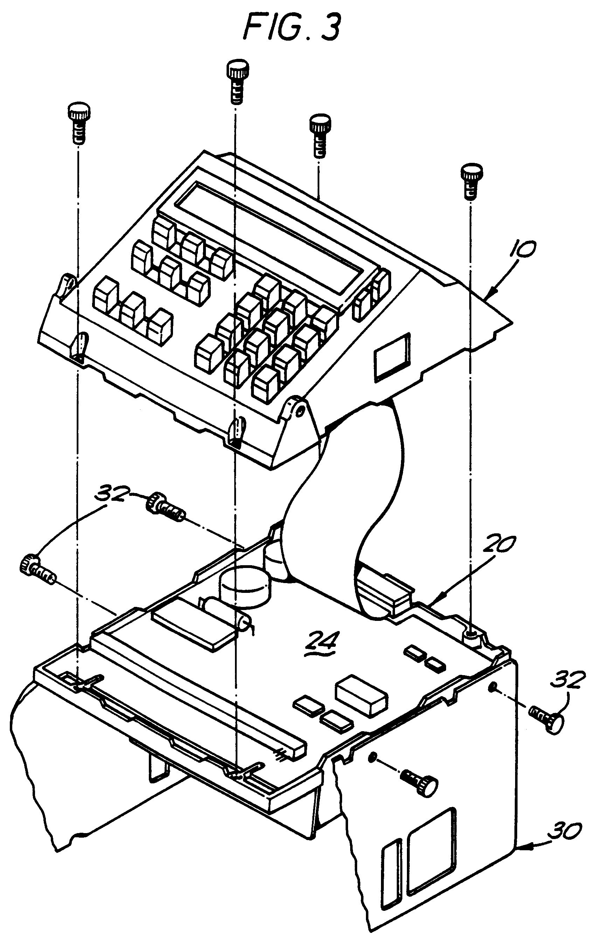

Referring firstly to Figures 1a-1g, these Figures illustrate the components of a first assembly 10 according to one particular example of the invention. In general terms the housing arrangement is made up of a first assembly 10 (Fig. 3) and a second assembly 20 (Fig. 3). The first assembly comprises a first die casting 12 having a front wall 12a, a rear wall 12b, side walls 12c and 12d, and a top wall 12e. The top wall 12e has apertures therein. The next component of the first assembly is a keypad 13 having an aperture 13a therein. Beneath the keypad 13 is positioned a display 14 and a display printed circuit board 14a. The display 14 is connected to a flying ribbon 14b. An insulating plate 15 is located beneath the board 14a and beneath this is located a metal support plate 16. The parts 12, 13, 14a, 15, 16 have aligned holes 16a therein, so that they can be connected together as a unit by suitable screws or bolts. One such bolt is illustrated in Figure 1g.

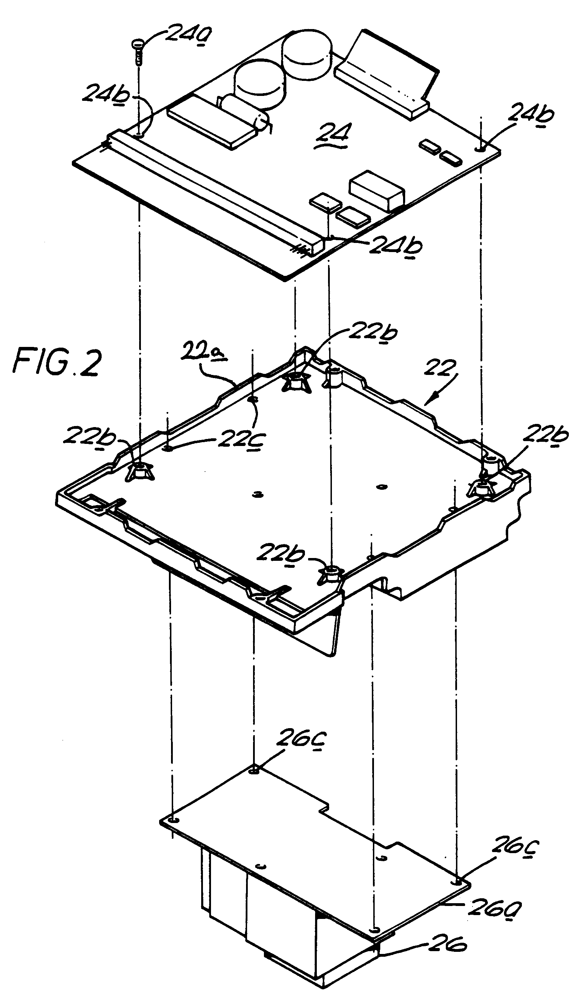

The second assembly comprises a second die casting 22, a main logic board 24, and a power supply unit 26. These are all seen in Figure 2. The second die casting is a generally planar die casting of a particular shape designed to co-operate and interfit with the first die casting 10. For this purpose it has an upstanding rim 22a and is provided with appropriately positioned through holes 22b. The main logic board has through holes 24b which are aligned in registry with the holes 22b of the die casting, so as to permit assembly. A so-called "Taptite" screw 24a for effecting this connection is shown at the top of Figure 2.

The second die casting 22 also has through holes 22c which are arranged in registry with holes 26c in a plate 26a which forms part of the power supply unit 26.

Figure 3 illustrates the two assemblies so far described, and this figure also shows side plates 30 which are attached to the second die casting 22 by self tapping screws 32. The screws 32 may be "Taptite" screws. The plates 30 are of metal and serve as part of a heat sink which includes the die casting 22 and, to a lesser extent, the die casting 12. The close physical connection between the parts 12, 22 and 30 permits heat generated in the power supply unit 26 to be effectively disipated, thereby avoiding undesirable over-heating.

It will be appreciated that modifications may be made to the disclosed and illustrated arrangement without departing from the invention. For example, fastening clips or other securing means could be employed if desired to connect together the first and second die castings 12 and 22. While components have been illustrated in Figure 3 on the upper side of the main logic board 24, it would still be within the present invention to locate certain components on its underside. For certain applications, it may be necessary to include additional insulating plates or support plates within the first assembly 10. Different specific shapes could be employed for the insulating and support plates to meet particular requirements.

## Claims

1. A housing arrangement for use in a device including a keypad (13), a display (14), a main logic circuit board (24), and a power supply unit (26), the housing arrangement comprising:
(I) a first assembly (10) comprising (a) a first die casting (12) of zinc or other material having equivalent radio frequency interference shielding and electromagnetic induction shielding properties, (b) the keypad (13), and (c) the display (14); and
(II) a second assembly (20) comprising a second die casting (22) to an upper surface of which is attached the main logic circuit board (24) and to a lower surface of which is attached the power supply unit (26), the second die casting being of a shape designed to cooperate and interfit with the first die casting.

2. A housing arrangement according to claim 1 in which the die casting (12) of the first assembly has front, rear, and two side walls (12a, 12b, 12c, 12d) all integral with a sloping apertured top wall (12e).

3. A housing arrangement according to claim 1 or 2 in which the die casting (22) of the second assembly is substantially planar and has a rim (22a) which interfits with the lower edges of the die casting (12) of the first assembly.

4. A housing arrangement according to any preceding claim in which the first assembly (10) comprises, assembled together in order, a metal support plate (16), an insulating plate (15), the display (14) attached to a display support board (14a), the keypad (13), and the first die casting (12), the first die casting (12) being uppermost.

5. A housing arrangement according to any preceding claim in which a so-called flying ribbon (14b) comprising multiple electrical conductors is connected at one end to the display (14) and at the other end to the main logic board (24).

6. A housing arrangement according to any preceding claim in which metal plates (30) serving as heat sinks are attached to the second die casting (22).

7. A housing arrangement according to claim 6 in which the metal plates (30) are attached to and one at each side of the second die casting (22).

## Patentansprüche

1. Gehäuseaufbau für die Verwendung bei einer Vorrichtung, welche eine Tastatur (13), eine Anzeige (14), eine logische Hauptschaltkreisplatine (24) und eine Stromversorgungseinheit (26) einschließt, wobei der Gehäuseaufbau aufweist:
(I) eine erste Baugruppe (10), die (a) ein erstes Druckgußteil (12) aus Zink oder einem anderen Material, welches gleichwertige Abschirmungseigenschaften gegen Radiofrequenzinterferenz und gegen elektromagnetische Induktion hat, (b) die Tastatur (13) und (c) die Anzeige (14) aufweist, und
(II) eine zweite Baugruppe (20), die ein zweites Druckgußteil (22) aufweist, an dessen oberer Fläche bzw. Oberseite die logische Hauptschaltkreisplatine (24) und an dessen unterer Seite die Stromversorgungseinheit (26) angebracht ist, wobei das zweite Druckgußteil eine Form hat, die dafür ausgelegt ist, mit dem ersten Druckgußteil zusammenzuwirken und zusammenzupassen.

2. Gehäuseanordnung nach Anspruch 1, wobei das Druckgußteil (12) der ersten Baugruppe eine vordere, eine hintere und zwei Seitenwände (12a, 12b, 12c, 12d) hat, die allesamt einstückig mit einer geneigten, mit Öffnung versehenen oberen Wand (12e) einstückig sind.

3. Gehäuseaufbau nach Anspruch 1 oder 2, wobei das Druckgußteil (22) der zweiten Baugruppe im wesentlichen eben ist und einen Flanschrand (22a) aufweist, der mit den unteren Rändern des Druckgußteiles (12) der ersten Baugruppe zusammen paßt.

4. Gehäuseaufbau nach einem der vorstehenden Ansprüche, wobei die erste Baugruppe (10) in einer Reihe zusammenmontiert aufweist: eine metallische Trägerplatte (16), eine isolierende Platte (15), die an einer Anzeigeträgerplatte (14a) angebrachte Anzeige (14), die Tastatur (13) und das erste Druckgußteil (12), wobei das erste Druckgußteil (12) das am weitesten oben liegende ist.

5. Gehäuseaufbau nach einem der vorstehenden Ansprüche, wobei ein sogenanntes Flachbandkabel (14b), welches mehrere elektrische Leiter aufweist, an einem Ende mit dem Display und am anderen Ende mit der logischen Hauptplatine (24) verbunden ist.

6. Gehäuseaufbau nach einem der vorstehenden Ansprüche, bei welchem Metallplatten (30), die als Wärmesenken dienen, an dem zweiten Druckgußteil (22) angebracht sind.

7. Gehäuseaufbau nach Anspruch 6, wobei die Metallplatten (30) an dem zweiten Druckgußteil (22) und auf jeder Seite desselben angebracht sind.

## Revendications

1. Arrangement de boîtier pour une utilisation dans un dispositif comprenant un clavier numérique (13), un affichage (14), une carte imprimée logique principale (24) et un bloc d'alimentation (26), l'arrangement de boîtier comprenant :
(I) un premier montage (10) comprenant (a) un premier moulage en coquille (12) de zinc ou d'autre matériau ayant une protection contre des interférences de fréquences radio et des propriétés de protection contre l'induction électromagnétique, (b) le clavier numérique (13) et (c) l'affichage (14) ; et
(II) un deuxième montage (20) comprenant un deuxième moulage en coquille (22) sur une surface supérieure duquel est fixée la carte logique principale (24) et sur une surface inférieure duquel est fixé un bloc d'alimentation (26), le deuxième moulage en coquille étant d'une forme conçue pour coopérer avec le premier moulage en coquille et s'ajuster à celui-ci.

2. Arrangement de boîtier selon la revendication 1, dans lequel le moulage en coquille (12) du premier montage a des parois frontale, arrière et deux parois latérales (12a, 12b, 12c, 12d) toutes solidaires avec une paroi de dessus ouverte inclinée (12e).

3. Arrangement de boîtier selon la revendication 1 ou 2, dans lequel le moulage en coquille (22) du deuxième montage est substantiellement plan et a un rebord (22a) qui s'ajuste avec les bords inférieurs du moulage en coquille (12) du premier montage.

4. Arrangement de boîtier selon l'une quelconque des revendications précédentes, dans lequel le premier montage (10) comprend, montés ensemble dans l'ordre, une plaque support métallique (16), une plaque isolante (15), l'affichage (14) fixé à la carte support d'affichage (14a), le clavier numérique (13) et le premier moulage en coquille (12), le premier moulage en coquille (12) étant au-dessus.

5. Arrangement de boîtier selon l'une quelconque des revendications précédentes, dans lequel un ruban dit volant (14b), comprenant de multiples conducteurs électriques, est connecté à une extrémité à l'affichage (14) et à l'autre extrémité, à la carte logique principale (24).

6. Arrangement de boîtier selon l'une quelconque des revendications précédentes, dans lequel des plaques métalliques (30) servant de récepteurs thermiques sont fixées au deuxième moulage en coquille (22).

7. Arrangement de boîtier selon la revendication 6, dans lequel les plaques métalliques (30) sont fixées, l'une de chaque côté, au deuxième moulage en coquille.
